# EUROPEAN PATENT APPLICATION

(11) **EP 4 790 496 A1**
(43) Date of publication of application: **12.08.2026**
(21) Application number: 25305189.0
(22) Date of filing: 11.02.2025
(51) Int. Cl.: G05B 19/04, G05B 19/042

(54) **METHODS FOR CONFIGURING A RECEPTOR APPARATUS AND APPARATUSES FOR IMPLEMENTING THE SAME**

(71) Applicant: SCHNEIDER ELECTRIC INDUSTRIES SAS, 92500 Rueil-Malmaison (FR)
(72) Inventor: FRUCHARD, Bertrand, 16340 L'ISLE D'ESPAGNAC (FR); ROBELIN, Arnaud, 16170 VAL D'AUGE (FR); LEBAD, Ammar, 16000 ANGOULEME (FR); HINTZY, Julien, 16130 CHAMPNIERS (FR)
(74) Representative: Plasseraud IP

(57) **Abstract**

A method for configuring a receptor apparatus adapted for processing an analog electrical input signal received from a source apparatus, the method comprising, the source apparatus being electrically coupled to the receptor apparatus through an input interface comprising a first and second input signal terminals of the receptor apparatus: Performing, by the receptor apparatus, second measurements of a voltage at the first and second input signal terminals, determining, by the receptor apparatus, based on the second measurements of the voltage, whether the analog electrical input signal is a voltage input signal, upon determining that the analog electrical input signal is a voltage input signal, configuring the input interface as a voltage input for processing the input signal as a voltage input signal and upon determining that the analog electrical input signal is a current input signal, configuring the input interface as a current input for processing the input signal as a current input signal.

## Description

The present disclosure relates to the configuration of a receptor apparatus adapted for processing an analog electrical input signal received from a source apparatus, in particular to the configuration of an analog input apparatus on which a source apparatus is connected.

When using an industrial analog input product, for example for connecting an analog sensor, the user must choose manually the appropriate input or product reference suitable for their analog sensor.

There are two major families of analog sensors: sensors providing information in electric current (amperes) and sensors providing information in the form of electric voltage (volts).

As a consequence, in order to cover different use cases, manufacturers of analog input products offer either products with both types of inputs (voltage and current inputs) or two separate product references.

There is therefore a need for providing improved schemes for configuring an analog input apparatus and apparatuses implementing the same that address at least some of the above-described drawbacks and shortcomings of the conventional technology in the art.

It is an object of the present subject disclosure to provide improved schemes for configuring an analog input apparatus and apparatuses implementing the same.

Another object of the present subject disclosure is to provide an improved scheme for configuring a receptor apparatus adapted for processing an analog electrical input signal received from a source apparatus (e.g. a sensor apparatus) and apparatus implementing the same for alleviating the above-described drawbacks and shortcomings of conventional schemes.

To achieve these objects and other advantages and in accordance with the purpose of the present subject disclosure, as embodied and broadly described herein, in one aspect of the present subject disclosure, a method for configuring a receptor apparatus adapted for processing an analog electrical input signal received from a source apparatus (e.g. a sensor). The proposed method comprises, the source apparatus being electrically coupled to the receptor apparatus through an input interface comprising a first and second input signal terminals of the receptor apparatus (so that the analog electrical input signal is received by the receptor apparatus):
performing one or more iterations of a configuration loop. In one or more embodiments, an iteration of the configuration loop may comprise one or more of the following operations: performing, by the receptor apparatus, one or more second measurements of a voltage (VIV) at the first and second input signal terminals; determining, by the receptor apparatus, based on the one or more second measurements of the voltage, whether the analog electrical input signal is a voltage input signal; upon determining that the analog electrical input signal is a voltage input signal, configuring the input interface as a voltage input for processing the input signal as a voltage input signal; upon determining that the analog electrical input signal is not a voltage input signal, determining whether the analog electrical input signal is a current input signal; upon determining that the analog electrical input signal is a current input signal, configuring the input interface as a current input for processing the input signal as a current input signal.

The proposed scheme advantageously allows an autodetection and configuration of an analog input product with respect to whether an analog input electrical signal received by the analog input product is a voltage signal or a current signal.

In particular, an analog input implementing one or more embodiments of the proposed scheme may advantageously automatically detect whether an analog input electrical signal received by the analog input product is a voltage signal or a current signal, and perform auto-configuration according to the detected type of analog input product.

As a consequence, the present subject disclosure provides an improved analog input device (apparatus) which advantageously exhibits versatility with respect to the type of analog input electrical signal received from a source apparatus (e.g. a sensor) outputting an analog input electrical signal to the improved analog input device. In addition, the improved analog input device (apparatus) of the present subject disclosure may in some embodiments be self-configurable accordingly.

The proposed scheme is therefore particularly advantageous for the deployment of analog input devices that are capable of adapting to the type of a sensor connected to the analog input device with respect to whether the sensor outputs a voltage signal or a current signal provided as analog electrical input signal fed to the analog input device.

In addition, the proposed improved schemes and apparatuses advantageously allow interchangeability of the source apparatus connected to an improved apparatus, so that a source apparatus outputting an analog electrical signal of a given type (e.g. current or voltage) connected to an improved apparatus of the present subject disclosure may be replaced by another source apparatus which may output an analog electrical signal of a different type. Upon connecting the other source apparatus to the improved apparatus, the improved apparatus may advantageously automatically detect the type of analog electrical signal provided as input by the other source apparatus, and in some embodiments may auto-configure accordingly.

Further, advantageously, the improved schemes and apparatuses of the present subject disclosure alleviate the need for a user to select a specific analog input device product reference which is specifically adapted to an application (e.g. which is adapted to the signal outputted by a source apparatus (e.g. a sensor) to be connected (electrically coupled) to an improved apparatus of the present subject disclosure). Such auto-detection feature of the type of analog input electrical signal received from a source apparatus and - in some embodiments - auto-configuration feature also advantageously open the path for configuring the improved apparatus for protecting the source apparatus.

In one or more embodiments, the determining whether the analog electrical input signal is a current input signal may comprise: determining, based on the one or more second measurements of the voltage, whether or not an indetermination case is reached.

In one or more embodiments, the proposed method may further comprise: determining that the analog electrical input signal is not a current input signal upon determining that an indetermination case is reached.

In one or more embodiments, the proposed method may further comprise: prior to performing the one or more second measurements of the voltage (VIV) at the first and second input signal terminals, connecting, by the receptor apparatus, a bias load (in the receptor apparatus) to the first and second input signal terminals; and upon performing the one or more second measurements of the voltage (VIV) at the first and second input signal terminals, disconnecting, by the receptor apparatus, the bias load.

In one or more embodiments, the determining whether the analog electrical input signal is a current input signal may comprise one or more of the following: performing one or more first measurements of a current (VIA) at one of the first and second terminals of the receptor apparatus; performing shunt of the first and second terminals of the receptor apparatus by configuring a shunt resistor in parallel between the first and second terminals of the receptor apparatus; upon performing a current injection in the first terminal of the receptor apparatus, performing one or more second measurements of a current (VIAV) at one of the first and second terminals of the receptor apparatus; determining, based on comparing the one or more second measurements of a current (VIAV) with a combination (e.g. a sum) of the one or more first measurements of a current (VIA) and the current injection, whether the analog electrical input signal is a current input signal. In some embodiments, the proposed method may further comprise: performing a plurality of the second measurements of the current (VIAV), wherein the determining whether the analog electrical input signal is a current input signal is based on a mean of the plurality of the second measurements of the current (VIAV). In one or more embodiments, the proposed method may further comprise: prior to performing the one or more second measurements of the current (VIAV), connecting, by the receptor apparatus, a bias load (in the receptor apparatus) to the first and second input signal terminals; and upon performing the one or more second measurements of a current (VIAV), disconnecting, by the receptor apparatus, the bias load.

In one or more embodiments, the proposed method may further comprise: performing a plurality of the second measurements of the current (VIAV). In some embodiments, the determining whether the analog electrical input signal is a current input signal may be based on a mean of the plurality of the second measurements of the current (VIAV).

In one or more embodiments, the proposed method may further comprise: performing a plurality of the first measurements of the current (VIA). In some embodiments, the determining whether the analog electrical input signal is a current input signal may be based on a mean of the plurality of the first measurements of the current (VIA).

In some embodiments, the proposed method may further comprise: determining whether the one or more first measurements of a current (VIA) belong to a range of rated current values for the analog electrical input signal (e.g. in some embodiments in the range [I_{MIN} - I_{MAX}] defined in chapter 6.5.2 of the international standard specification IEC 61131-2 of the International Electrotechnical Commission).

In one or more embodiments, the determining, based on the one or more second measurements of the voltage, whether the analog electrical input signal is a voltage input signal may comprise comparing the one or more second measurements of the voltage with a predefined voltage value (e.g. a predefined voltage minimum threshold, V_TH_MIN).

In one or more embodiments, the proposed method may further comprise: prior to performing the one or more second measurements of the voltage (VIV) at the first and second input signal terminals, configuring an electrical analog input of the receptor as a voltage input.

In one or more embodiments, the proposed method may further comprise one or more of the following: performing one or more first measurements of a voltage (VIC) at the first and second input signal terminals; determining whether the one or more first measurements of the voltage belong to a range of rated voltage values for the analog electrical input signal (e.g. in some embodiments in the range [V_{MIN} - V_{MAX}] defined in chapter 6.5.2 of the international standard specification IEC 61131-2 of the International Electrotechnical Commission).

In one or more embodiments, the proposed method may further comprise: performing a plurality of the second measurements of the voltage (VIV), wherein the determining whether the analog electrical input signal is a voltage input signal is based on a mean of the plurality of the second measurements of the voltage.

In one or more embodiments, the proposed method may further comprise one or more of the following: performing a plurality of the first measurements of a voltage (VIC) at the first and second input signal terminals; determining a representative first voltage measurement value based on the plurality of first measurements of a voltage (VIC); determining whether the representative first voltage measurement value belongs to a range of rated voltage values for the analog electrical input signal (e.g. in some embodiments in the range [V_{MIN} - V_{MAX}] defined in chapter 6.5.2 of the international standard specification IEC 61131-2 of the International Electrotechnical Commission).

In one or more embodiments, the representative first voltage measurement value may be determined based on a mean of the plurality of first measurements of a voltage (VIC) at the first and second input signal terminals.

In one or more embodiments, the proposed method may further comprise: upon determining that the one or more first measurements of the voltage do not belong to the range of rated voltage values for the analog electrical input signal, determining a configuration error of the receptor apparatus.

In one or more embodiments, the proposed method may further comprise: upon determining that the one or more first measurements of a current (VIA) do not belong to a range of rated current values for the analog electrical input signal, performing another iteration of the configuration loop.

In another aspect of the present subject disclosure, an apparatus is proposed, which comprises a processor and a memory operatively coupled to the processor, wherein the apparatus is configured to perform a method as proposed in the present subject disclosure.

In yet another aspect of the present subject disclosure, a non-transitory computer-readable medium encoded with executable instructions which, when executed, causes an apparatus comprising a processor operatively coupled with a memory, to perform a method as proposed in the present subject disclosure, is proposed.

In yet another aspect of the present subject disclosure, a computer program product comprising computer program code tangibly embodied in a computer readable medium, said computer program code comprising instructions to, when provided to a computer system and executed, cause said computer to perform a method as proposed in the present subject disclosure, is proposed. In another aspect of the present subject disclosure, a data set representing, for example through compression or encoding, a computer program as proposed herein, is proposed.

It should be appreciated that the present subject disclosure can be implemented and utilized in numerous ways, including without limitation as a process, an apparatus, a system, a device, and as a method for applications now known and later developed. These and other unique features of the system disclosed herein will become more readily apparent from the following description and the accompanying drawings.

### Brief description of the drawings

The present subject disclosure will be better understood and its numerous objects and advantages will become more apparent to those skilled in the art by reference to the following drawings, in conjunction with the accompanying specification, in which:
Figure 1 shows an exemplary industrial network according to one or more embodiments of the present subject disclosure;
Figure 2 illustrates an exemplary scheme for configuring a receptor apparatus according to one or more embodiments of the present subject disclosure;
Figure 3 illustrates an apparatus according to one or more embodiments of the present subject disclosure;
Figs. 4A and 4B show a diagram illustrating a method for self configuring a receptor apparatus according to one or more embodiments of the present subject disclosure;
Fig. 5 shows a diagram illustrating a method for self configuring a receptor apparatus according to one or more embodiments of the present subject disclosure; and
Figure 6A and 6B illustrate an apparatus according to one or more embodiments of the present subject disclosure.

### Description of embodiments

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. Certain figures may be shown in an idealized fashion in order to aid understanding, such as when structures are shown having straight lines, sharp angles, and/or parallel planes or the like that under real-world conditions would likely be significantly less symmetric and orderly. The same reference numerals in different figures denote the same elements, while similar reference numerals may, but do not necessarily, denote similar elements.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to apparatuses, devices, modules, units, functions, engines, block diagrams and flowchart illustrations of the methods, systems, and computer program according to one or more exemplary embodiments. Each described apparatus, device, module, unit, function, engine, block of the block diagrams and flowchart illustrations can be implemented in hardware, software, firmware, middleware, microcode, or any suitable combination thereof. If implemented in software, the apparatuses, devices, modules, units, functions, engines, blocks of the block diagrams and/or flowchart illustrations can be implemented by computer program instructions or software code, which may be stored or transmitted over a computer-readable medium, or loaded onto a general purpose computer, special purpose computer or other programmable data processing apparatus to produce a machine, such that the computer program instructions or software code which execute on the computer or other programmable data processing apparatus, create the means for implementing the functions described herein.

Embodiments of computer-readable media includes, but are not limited to, both computer storage media and communication media including any medium that facilitates transfer of a computer program from one place to another. As used herein, a "computer storage media" may be any physical media that can be accessed by a computer or a processor. In addition, the terms « memory » and « computer storage media" include any type of data storage device, such as, without limitation, a hard drive, a flash drive or other flash memory devices (e.g. memory keys, memory sticks, key drive, SSD drives), CD-ROM or other optical storage, DVD, magnetic disk storage or other magnetic storage devices, memory chip(s), Random Access Memory (RAM), Read-Only-Memory (ROM), Electrically-erasable programmable read-only memory (EEPROM), smart cards, or any other suitable medium that can be used to carry or store program code in the form of instructions or data structures which can be read by a computer processor, or a combination thereof. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Python, Visual Basic, SQL, PHP, and JAVA.

Unless specifically stated otherwise, it will be appreciated that throughout the following description discussions utilizing terms such as processing, computing, calculating, determining, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

As used herein, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

Additionally, the word "exemplary" is used herein to mean "serving as an example, instance, or illustration". Any embodiment or design described herein as "exemplary" is not necessarily to be construed as preferred or advantageous over other embodiments or designs.

In the present subject disclosure, the terms "coupled" and "connected", along with their derivatives, may be indifferently used to indicate that two or more elements are in direct physical or electrical contact with each other, or two or more elements are not in direct contact with each other, but yet still co-operate or interact with each other.

In the present subject disclosure, the terms "analog", "analog subassembly" and "analog part" are used indiscriminately in this description to refer to subassemblies of one or more electronic components (which are then referred to as "analog") configured to receive and/or process analog signals.

It should be understood that embodiments of the present subject disclosure may be used for configuring an analog (input) device (apparatus, module) for processing an analog electrical input signal received from a source apparatus (e.g. a sensor apparatus) to which it is electrically connected (e.g. through one or more electrical terminals), with respect to the type of analog electrical input signal (e.g. voltage input signal or current input signal), in particular, although not limited to, configuring an analog (input) device (apparatus, module) for processing an analog electrical input signal received from a sensor apparatus to which it is electrically connected.

In some embodiments, any suitable analog device may be configured to implement one of the proposed schemes of the present disclosure during an initialization phase of the analog device executed once the analog device is electrically connected to a source apparatus.

In the following, embodiments of the present subject disclosure may be described in reference to the exemplary standard specification IEC 61131-2, for purposes of illustration. However, it will be appreciated by those having ordinary skill in the relevant art that embodiments of the present subject disclosure may be implemented in any suitable apparatus (device), such as for example any suitable analog input device, configured to comply with or to follow specifications of any suitable standard specification(s) other than the standard specification IEC 61131-2 which is given by way of example only.

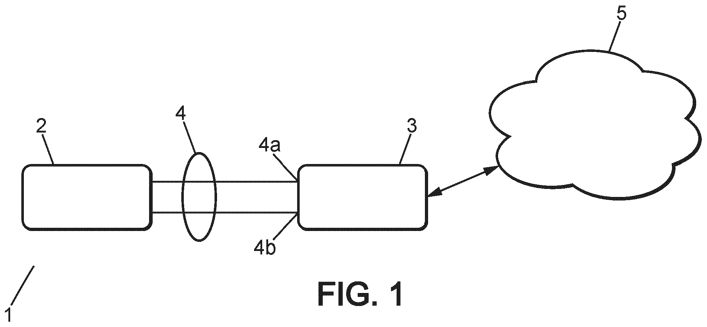

In an industrial network, various nodes may be connected to each other through electrical coupling. For example, in the exemplary industrial network (1) illustrated in Fig. 1, a sensor node (2) may be electrically coupled to an analog input node (3). The sensor node (2) may be configured to output to the analog input node (3) an analog electrical input signal, which may be fed to the analog input node through two terminals (4a, 4b) of the electrical coupling (4) with the sensor node (3).

In some embodiments, the analog input node (3) may be further connected (including communicatively coupled) to an industrial sub-network (5) of the industrial network (1).

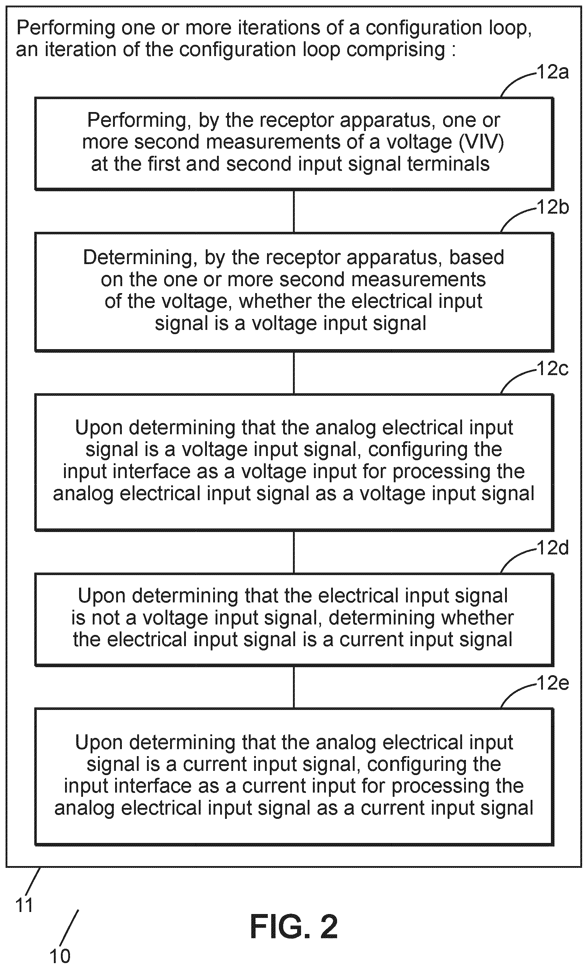

Figure 2 is a diagram that illustrates an exemplary scheme (10) for configuring a receptor apparatus (e.g. an analog input apparatus) according to one or more embodiments of the present subject disclosure.

One considers a receptor apparatus adapted for processing an analog electrical input signal received from a source apparatus, such as for example the analog input node (3) and the sensor node (2) shown on Fig. 1. The source apparatus may be electrically coupled to the receptor apparatus, for example through an input interface comprising a first and second input signal terminals of the receptor apparatus, so that the source apparatus may feed an analog electrical input signal to the receptor apparatus.

In one or more embodiments, one or more iterations of a configuration loop may be performed (11) for configuration of the receptor apparatus.

In one or more embodiments, an iteration of the configuration loop may comprise one or more of the following operations:
In one or more embodiments, an iteration of the configuration loop may comprise: connecting (not represented on the Figure), by the receptor apparatus, a bias load (in the receptor apparatus) (e.g. a bias resistor) to the first and second input signal terminals of the receptor apparatus. In some embodiment, a Direct Current (DC) bias may be added in the analog input circuit of the receptor apparatus, for example by connecting in parallel a current source. Adding a DC bias to the analog input circuit of the receptor apparatus may be used for measuring the Equivalent Series Resistor of the source apparatus electrically coupled to the receptor apparatus.

In one or more embodiments, an iteration of the configuration loop may comprise: performing (12a), by the receptor apparatus, one or more second measurements of a voltage (VIV) at the first and second input signal terminals through which the receptor apparatus is connected to the source apparatus. In some embodiments, the one or more second measurements may be performed further to performing a current injection in the source apparatus to which the receptor apparatus is connected.

The bias load that may have been connected in some embodiments to the first and second input signal terminals of the receptor apparatus prior to performing the one or more second measurements of voltage (VIV) at the first and second input signal terminals may be disconnected once the measurements are complete, in some embodiments prior to performing the following subsequent operations of the configuration loop iteration.

In one or more embodiments, an iteration of the configuration loop may comprise: determining (12b), by the receptor apparatus, based on the one or more second measurements of the voltage, whether the analog electrical input signal is a voltage input signal. In some embodiments, the receptor apparatus may determine that the analog electrical input signal outputted by the source apparatus is a voltage input signal based on a comparison of the one or more second measurements of the voltage with a predetermined voltage value. In some embodiments, the receptor apparatus may determine that the analog electrical input signal outputted by the source apparatus is a voltage input signal based on determining that one or more of the one or more second measurements of the voltage are below a predetermined voltage value.

In some embodiments, the predetermined voltage value may be the lower bound V_{Min} of a predetermined range of voltage values [V_{Min}, V_{Max}].

In one or more embodiments, an iteration of the configuration loop may comprise: upon determining that the analog electrical input signal is a voltage input signal, configuring (12c) the input interface of the receptor apparatus (comprising the first and second input signal terminals) as a voltage input for processing the input signal as a voltage input signal. Once it has been determined that the analog electrical input signal is a voltage input signal, the input interface of the receptor apparatus may in some embodiments be configured with a high impedance referred to as a "voltage input impedance" (for example with an input resistor configured between the first and second input signal terminals of a value higher than a predefined voltage input impedance). Depending on the embodiment, the voltage input impedance may be chosen of the order of 10 kOhms (consistent with voltage values specified by the standard specification IEC 61131-2 for a voltage input), or may be chosen to be several orders of magnitude higher than values that would be consistent voltage values specified by an applicable standard specification (e.g. IEC 61131-2) for a voltage input (e.g. in the order of 100 kOhms) (in order to advantageously protect the source apparatus by limiting the current flow that flows through the source apparatus when connected to the receptor apparatus).

In some embodiments, the configuring of the input interface of the receptor apparatus (comprising the first and second input signal terminals) as a voltage input may use electronic switches, for example driven by a microcontroller of the receptor apparatus, to configure a high input (resistive) impedance to perform voltage measurement(s) or a low input (resistive) impedance to perform current measurement(s) (for example using one or more shunt resistors).

In one or more embodiments, an iteration of the configuration loop may comprise: upon determining that the analog electrical input signal is not a voltage input signal, determining (12d) whether the analog electrical input signal is a current input signal.

In one or more embodiments, an iteration of the configuration loop may further comprise: upon determining that the analog electrical input signal is a current input signal, configuring (12e) the first and second input signal terminals as a current input for processing the input signal as a current input signal.

Once it has been determined that the analog electrical input signal is a current input signal, the input interface of the receptor apparatus may be configured with a low impedance referred to as a "current input impedance" (for example with an input resistor configured between the first and second input signal terminals of a value corresponding to a predefined current input impedance). Depending on the embodiment, the voltage input impedance may be chosen of the order of 500 Ohms (consistent with current values specified by the standard specification IEC 61131-2 for a current input).

In some embodiments, the determination as to whether the analog electrical input signal is a voltage input signal may be performed before the determination as to whether the analog electrical input signal is a current input signal. As the measurements performed for the determination as to whether the analog electrical input signal is a voltage input signal may in some embodiments involve configuring the input interface of the receptor apparatus with a high impedance (voltage input impedance) for performing the measurements, the source apparatus may be advantageously protected by the high input impedance configured in the receptor impedance, which protection may be advantageous as long as a determination as to whether the analog electrical input signal is a voltage input signal is yet to be made. In cases where a determination that the analog electrical input signal is not a voltage input signal is made, a determination as to whether the analog electrical input signal is a current input signal may be performed, which determination may not use the protecting of the source apparatus provided by a high input impedance as it will have already been determined that the analog electrical input signal is not a voltage input. The determination as to whether the analog electrical input signal is a current input signal may in some embodiments involve configuring the input interface of the receptor apparatus with a low impedance (current input impedance) for performing the measurements involved in the determination, which low impedance may be too low for efficiently protecting the source apparatus from high current flows.

In one or more embodiments, the determining whether the analog electrical input signal is a current input signal may comprise one or more of the following operations: In some embodiments, one or more first measurements of a current (VIA) may be performed at one of the first and second terminals of the receptor apparatus. Advantageously, the one or more first measurements of a current (VIA) may not require any current injection, and may be performed without any such current injection.

In some embodiments, one or more second measurements of a current (VIAV) at one of the first and second terminals of the receptor apparatus may be performed at one of the first and second terminals of the receptor apparatus further to performing a current injection (in some embodiments of the order of a few mA, e.g. 1 mA) in the one of the first and second terminals of the receptor apparatus may be performed at one of the first and second terminals of the receptor apparatus.

In embodiments where several second measurements of a current (VIAV) are performed, a plurality of current injections may be performed. Depending on the embodiment, the plurality of current injections may be performed with approximately the same current value, which advantageously results in a lower complexity implementation of the receptor apparatus, or may be performed with different values, which may advantageously improve the reliability of the detection of the type of input signal proposed in the present disclosure, however at the expense of a higher complexity implementation.

In some embodiments, prior to performing the current measurement with the current injection, a shunt resistor may be applied (configured)(connected) in parallel between the first and second terminals for performing shunt of the first and second terminals of the receptor apparatus.

In some embodiments, prior to performing the current measurement with the current injection, a bias resistor may also be applied (configured)(connected) in parallel to the shunt resistor between the first and second terminals for setting the bias between the first and second terminals of the receptor apparatus.

In some embodiments, the shunt resistor may advantageously be used to convert a current signal provided by the source apparatus (e.g. a sensor), which may be for example in the range 0 - 20mA, into a voltage signal that can be processed by an analog digital converter (ADC) of a micro-controller of the receptor apparatus.

In one or more embodiments, the shunt resistor may be connected to terminals of the source apparatus (e.g. a terminal of the source apparatus through which the source signal is received, and a ground terminal). The value of the shunt resistor may in some embodiments be chosen to be low (for example not greater than 500 Ohms) in order to comply with the requirements of the standard specification IEC 61131-2.

In one or more embodiments, the bias resistor may advantageously be used to add, to the analog electrical input signal received from the source apparatus, an error signal, to be used to determine the type of this analog electrical input signal (voltage signal or current signal) according to embodiments of the present subject disclosure.

In one or more embodiments, the bias resistor may be configured to be dynamically adjusted, and may be connected between a power supply of the receptor apparatus (power supply which is not accessible to the source apparatus), and a terminal of the source apparatus through which the source signal is received (e.g. to a terminal of the source apparatus through which the source apparatus is connected to the receptor apparatus).

In some embodiments, the ohm value of the bias resistor may be determined to correspond to a current signal in the order of magnitude of 1 mA flowing through the bias resistor in cases where the power supply of the receptor apparatus and the terminal of the source apparatus are electrically coupled.

Once the one or more first measurements of a current (VIA) and one or more second measurements of a current (VIAV) have been performed, such measurements may be advantageously used for determining whether or not the analog electrical input signal is a current input signal.

For example, in some embodiments, one or more of the one or more second measurements of a current (VIAV) may be compared with a combination (e.g. based on a sum) of the one or more first measurements of a current (VIA) and the current injection in order to determine whether the analog electrical input signal is a current input signal.

For example, in some embodiments, one or more of the one or more second measurements of a current (VIAV) may be compared to a sum of a representative first current measurement value which is based on one or more of the one or more first measurements of a current (VIA), and an offset value determined based on the current injection used for performing the one or more second measurements of a current (VIAV). The test on the one or more second measurements of a current (VIAV) for determining whether or not the analog electrical input signal is a current input signal may for example be formulated as follows: $VIAV ≅ VIA + Injection Current ?$

In one or more embodiments, a plurality of the second measurements of the current (VIAV) may be performed, and the determining whether the analog electrical input signal is a current input signal may be based on a mean (VIAVm) of the plurality of the second measurements of the current (VIAV). Using a mean value advantageously reduces the measurement error associated with one measurement through using a mean (VIAVm) instead of a single measurement. Preferably, the number of the second measurements of the current (VIAV) may be chosen high enough in order to reduce a measurement uncertainty below a first predefined value.

Depending on the embodiment, any suitable mean formula may be used to determine the mean (VIAVm) of the plurality of the second measurements of the current (VIAV).

In one or more embodiments, a plurality of the first measurements of the current (VIA) may be performed, and the determining whether the analog electrical input signal is a current input signal may be based on a mean (VIAm) of the plurality of the first measurements of the current (VIA). Using a mean value advantageously reduces the measurement error associated with one measurement through using a mean (VIAm) instead of a single measurement. Preferably, the number of the first measurements of the current (VIA) may be chosen high enough in order to reduce a measurement uncertainty below a second predefined value. In some embodiments, the number of the first measurements of the current (VIA) may be chosen of the same order as (e.g. equal to) the number of the second measurements of the current (VIAV).

Depending on the embodiment, any suitable mean formula may be used to determine the mean (VIAm) of the plurality of the first measurements of the current (VIA).

In some embodiments, the representative first current measurement value based on one or more of the one or more first measurements of a current (VIA) which is used for the test on the one or more second measurements of a current (VIAV) for determining whether or not the analog electrical input signal is a current input signal may be based on a mean value (VIAm) of one or more of a plurality of first measurements of a current (VIA).

For example, in one or more embodiments, the test on the one or more second measurements of a current (VIAV) for determining whether or not the analog electrical input signal is a current input signal may use a mean value (VIAm) of one or more of a plurality of first measurements of a current (VIA), and a mean value (VIAVm) of one or more of a plurality of second measurements of a current (VIAV), and may for example be formulated as follows: $VIAVm ≅ VIAm + Injection Current ?$

In one or more embodiments, other tests for determining whether or not the analog electrical input signal is a current input signal may be performed in addition to or, depending on the embodiment, as an alternative to the test using the one or more second measurements of a current (VIAV) described above.

For example, a test for determining whether or not the analog electrical input signal is a current input signal may comprise: determining whether the one or more first measurements of a current (VIA) belong to a range of rated current values for the analog electrical input signal.

Depending on the embodiment, one or more of the one or more first measurements of a current (VIA) may be tested to determine whether or not a predefined percentage of such measurements value (e.g. all of the first measurements of a current values) belong to the range of rated current values for the analog electrical input signal.

In some embodiments, a mean value of one or more of the one or more first measurements of a current (VIA) (e.g. VIAm) may be tested to determine whether or not the mean value belongs to the range of rated current values for the analog electrical input signal.

Depending on the embodiment, the range of rated current values may be predetermined with one or more of an upper limit current value (Imax) and a lower limit current value (Imin). For example, the range of rated current values may be defined in a technical specification document that specifies rated current values for the source apparatus. For example, the range of rated current values may be defined in a technical specification of a standard, such as for example the IEC 61131-2 standard specification (in particular chapter 6.5.2 thereof) in the field of industrial automation.

Depending on the embodiment, one or more of the one or more first measurements of a current (VIA) may be tested against an upper limit current value (Imax) of a range of rated current values, against a lower limit current value (Imin) of a range of rated current values, or against both of an upper limit current value (Imax) and a lower limit current value (Imin) of a range of rated current values.

In one or more embodiments, the determining based on the one or more second measurements of the voltage whether the analog electrical input signal is a voltage input signal may comprise: comparing the one or more second measurements of the voltage with a predefined voltage value.

In some embodiments, the predefined voltage value may be chosen based on an estimated equivalent series resistor of the source apparatus. For example, the predefined voltage value may be chosen as a combination of a maximum rated voltage value for the source apparatus and a voltage offset corresponding to a voltage drop created by the estimated equivalent series resistor of the source apparatus.

In one or more embodiments, a plurality of the second measurements of the voltage (VIV) may be performed, and the determining whether the analog electrical input signal is a voltage input signal may be based on a mean (VIVm) of the plurality of the second measurements of the voltage (VIV). Using a mean value advantageously reduces the measurement error associated with one measurement through using a mean (VIVm) instead of a single measurement. Preferably, the number of the second measurements of the voltage (VIV) may be chosen high enough (e.g. in the order of 10) in order to reduce a measurement uncertainty below a third predefined value.

Depending on the embodiment, any suitable mean formula may be used to determine the mean (VIVm) of the plurality of the second measurements of the voltage (VIV).

For example, in one or more embodiments, a test on the one or more second measurements of a voltage (VIV) for determining whether or not the analog electrical input signal is a voltage input signal may use a mean value (VIVm) of one or more of a plurality of second measurements of a voltage (VIV), and may for example be formulated as follows: $VIVm \leq First _ Predefined _ Voltage _ Threshold ?$

In one or more embodiments, in a case where it is determined that the analog electrical input signal is not a voltage input signal, the proposed configuration scheme may proceed with determining whether or not the analog electrical input signal is a current input signal. In some embodiments, it may be determined that the analog electrical input signal is not a voltage input signal further to determining that a representative second voltage measurement value which is based on the one or more second measurements of a voltage (VIV) is not smaller or equal to a first predefined voltage threshold.

In one or more embodiments, further to determining that the analog electrical input signal is not a voltage input signal (for example using the representative second voltage measurement value), it may be determined whether an indetermination case is reached or whether a test for determining whether the analog electrical input signal is a current input signal may be performed.

In one or more embodiments, the determining whether the analog electrical input signal is a current input signal may comprise determining, based on the one or more second measurements of the voltage, whether or not an indetermination case is reached. For example, upon determining, for example based on the one or more second measurements of the voltage, that the analog electrical input signal is not a voltage input signal, the receptor apparatus may proceed with determining whether or not an indetermination case is reached. In some embodiments, upon (in case of) determining that an indetermination case is reached (as part of determining whether or not the analog electrical input signal is a current input signal), the current iteration of the configuration loop may be stopped, and a new iteration of the configuration loop may be performed. In some embodiments, upon (in case of) determining that an indetermination case is reached (as part of determining whether or not the analog electrical input signal is a current input signal), the current iteration of the configuration loop may be stopped, and based on a number of iterations of the configuration loop that have been performed, a determination that the analog electrical input signal is neither a voltage input signal or a current input signal may be made.

In one or more embodiments, the one or more second measurements of the voltage (VIV) may be used by the receptor apparatus to perform a determination as to whether or not the analog electrical input signal is a voltage input signal and a determination as to whether or not an indetermination case is reached.

For example, in some embodiments, a representative second voltage measurement value based on the one or more second measurements of the voltage (VIV) may be determined.

In one or more embodiments, the representative second voltage measurement value may be compared with a first predefined voltage threshold for determining whether or not the analog electrical input signal is a voltage input signal. For example, in some embodiments, a determination that the analog electrical input signal is a voltage input signal may be made upon determining that the representative second voltage measurement value is smaller than the first predefined voltage threshold. **In** some embodiments, a determination that the analog electrical input signal is not a voltage input signal may be made otherwise (e.g. upon determining that the representative second voltage measurement value is greater than the first predefined voltage threshold).

In one or more embodiments, the representative second voltage measurement value may be compared with a second predefined voltage threshold for determining whether or not an indetermination case is reached. In some embodiments, the second predefined voltage threshold may be chosen greater than the first predefined voltage threshold. For example, in some embodiments, a determination that an indetermination case is reached may be made upon determining that the representative second voltage measurement value is smaller than the second predefined voltage threshold. In some embodiments, a determination that an indetermination case is not reached may be made otherwise (e.g. upon determining that the representative second voltage measurement value is greater than the second predefined voltage threshold).

For example, in some embodiments, a determination that an indetermination case is reached may be made upon determining that the representative second voltage measurement value is greater than the first predefined voltage threshold and smaller than the second predefined voltage threshold. In some embodiments, a determination that an indetermination case is not reached may be made otherwise (e.g. upon determining that the representative second voltage measurement value is greater than the second predefined voltage threshold, in which case it will be also greater than the first predefined voltage threshold).

In some embodiments, upon determining that the representative second voltage measurement value is greater than the second predefined voltage threshold, the determination as to whether or not the analog electrical input signal is a current input signal may proceed further according to embodiments of the present subject disclosure.

For example, in some embodiments, the values of the first predefined voltage threshold and the second predefined voltage threshold may be chosen based on rated voltage values specified for the source apparatus, for example in the IEC 61131-2 standard specification (in particular chapter 6.5.2 thereof) for the field of industrial automation.

Specifically, in the exemplary case where the first predefined voltage threshold and the second predefined voltage threshold are chosen based on rated voltage values specified in chapter 6.5.2 of the IEC 61131-2 specification, the first predefined voltage threshold may be predefined to be 18 V, and the first predefined voltage threshold may be predefined to be 20 V.

In some embodiments, a representative second voltage measurement value determined based on the one or more second measurements of a voltage (VIV) may be used with respect to one or more of the first and second voltage threshold values. In some embodiments, in case where the representative second voltage measurement value is smaller than the first predefined voltage threshold (e.g. 18 V), a determination that the analog electrical input signal is a voltage input signal may be made. In some embodiments, in case where the representative second voltage measurement value is greater than the first predefined voltage threshold (e.g. 18 V) and smaller than the second predefined voltage threshold (e.g. 20 V), a determination that an indetermination case is reached may be made. In some embodiments, in case where the representative second voltage measurement value is greater than the second predefined voltage threshold (e.g. 20 V), the proposed scheme may further proceed to determine whether or not the analog electrical input signal is a current input signal.

In one or more embodiments, an additional test for determining whether or not the analog electrical input signal is a voltage input signal may be performed, and may comprise: prior to performing the one or more second measurements of the voltage (VIV) at the first and second input signal terminals, configuring an electrical analog input of the receptor as a voltage input. In some embodiments, configuring an electrical analog input of the receptor as a voltage input may comprise configuring the electrical analog input as a high impedance input. For example, according to the IEC 61131-2 standard specification, a voltage input may be configured to receive a voltage signal between 0V and 10V. In order to comply with such configuration, the receptor apparatus may be configured with an input resistor (input impedance) of at least 10 kOhms. In some embodiments, the input of the receptor apparatus may be configured with a high (resistive) impedance, for example in the order of 100 kOhms.

Using a high value input resistor (configured between the first and second input signal terminals) (for example of at least 100 kOhms) advantageously provides electrical protection of the source apparatus, as it will limit the amount of current flowing through the source apparatus once connected to the receptor apparatus.

In one or more embodiments, an additional test for determining whether or not the analog electrical input signal is a voltage input signal may comprise one or more of the following operations: performing one or more first measurements of a voltage (VIC) at the first and second input signal terminals, and determining whether the one or more first measurements of the voltage belong to a range of rated voltage values for the analog electrical input signal.

Depending on the embodiment, one or more of the one or more first measurements of a voltage (VIC) may be tested to determine whether or not a predefined percentage of such measurements value (e.g. all of the first measurements of a voltage value) belong to the range of rated voltage values for the analog electrical input signal.

In some embodiments, a mean value of one or more of the one or more first measurements of a voltage (VIC) (e.g. VICm) may be tested to determine whether or not the mean value belongs to the range of rated voltage values for the analog electrical input signal.

Depending on the embodiment, the range of rated voltage values may be predetermined with one or more of an upper limit voltage value (Vmax) and a lower limit voltage value (Vmin). For example, the range of rated voltage values may be defined in a technical specification document that specifies rated voltage values for the source apparatus. For example, the range of rated voltage values may be defined in a technical specification of a standard, such as for example the IEC 61131-2 standard specification (in particular chapter 6.5.2 thereof) in the field of industrial automation.

Depending on the embodiment, one or more of the one or more first measurements of a voltage (VIC) may be tested against an upper limit voltage value (Vmax) of a range of rated voltage values, against a lower limit voltage value (Vmin) of a range of rated voltage values, or against both of an upper limit voltage value (Vmax) and a lower limit voltage value (Vmin) of a range of rated voltage values.

In one or more embodiments, a plurality of the first measurements of the voltage (VIC) may be performed, and the determining whether the analog electrical input signal is a voltage input signal may be based on a mean (VICm) of the plurality of the first measurements of the voltage (VIC). Using a mean value advantageously reduces the measurement error associated with one measurement through using a mean (VICm) instead of a single measurement. Preferably, the number of the first measurements of the voltage (VIC) may be chosen high enough (e.g. 10 or more) in order to reduce a measurement uncertainty below a fourth predefined value. In some embodiments, the number of the first measurements of the voltage (VIC) may be chosen of the same order as (e.g. equal to) the number of the second measurements of the voltage (VIV).

Depending on the embodiment, any suitable mean formula may be used to determine the mean (VICm) of the plurality of the first measurements of the current (VIA).

In some embodiments, the representative first voltage measurement value based on one or more of the one or more first measurements of a voltage (VIC) which is used for performing a test for determining whether or not the analog electrical input signal is a voltage input signal may be based on a mean value (VICm) of one or more of a plurality of first measurements of a voltage (VIC).

For example, in some embodiments, a test for determining whether or not the analog electrical input signal is a voltage input signal may comprise determining whether or not the mean value (VICm) of one or more of a plurality of first measurements of a voltage (VIC) belongs to a range of rated voltage values for the analog electrical input signal.

For example, in one or more embodiments, the test on the one or more first measurements of a voltage (VIC) for determining whether or not the analog electrical input signal is a voltage input signal may use a mean value (VICm) of one or more of a plurality of first measurements of a voltage (VIC), and may for example be formulated as follows: $VICm \leq {Vrated}_{max} ?$

In one or more embodiments, upon determining that the one or more first measurements of the voltage do not belong to the range of rated voltage values for the analog electrical input signal, a configuration error of the receptor apparatus may be determined, and the current configuration loop iteration may be stopped. In some embodiments, another iteration of the configuration loop may then be initiated.

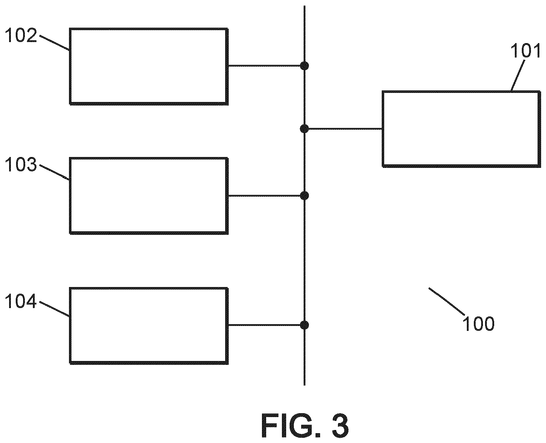

Figure 3 illustrates a receptor apparatus 100 configured to use features in accordance with embodiments of the present subject disclosure.

The receptor apparatus 100 may include a control engine 101, a configuration engine 102, a receptor interface engine 103, a memory 104, and a power supply (e.g., a battery, plug-in power supply, etc.) (not represented on the figure). The receptor apparatus 100 may be configured with a electrical signal interface (not represented on the figure) configured for electrically coupling the receptor apparatus to a source apparatus (through an input interface comprising a first and second input signal terminals of the receptor apparatus) for receiving an analog electrical input signal through the coupling interface (not represented on the figure).

In the architecture illustrated on Fig. 3, all of the configuration engine 102, receptor interface engine 103, and memory 104 are operatively coupled with one another through the control engine 101.
In one or more embodiments, the configuration engine 102 is configured to perform various aspects of embodiments of the proposed methods for configuring a receptor apparatus as described herein. For example, in some embodiments, the configuration engine 102 may be configured to perform one or more iterations of a configuration loop, an iteration of the configuration loop comprising: performing, by the receptor apparatus, one or more second measurements of a voltage (VIV) at the first and second input signal terminals; determining, by the receptor apparatus, based on the one or more second measurements of the voltage, whether the analog electrical input signal is a voltage input signal; upon determining that the analog electrical input signal is a voltage input signal, configuring the input interface as a voltage input for processing the input signal as a voltage input signal; upon determining that the analog electrical input signal is not a voltage input signal, determining whether the analog electrical input signal is a current input signal; upon determining that the analog electrical input signal is a current input signal, configuring the input interface as a current input for processing the input signal as a current input signal.

In one or more embodiments, the receptor interface engine 103 is configured to manage an electrical signal interface with the source apparatus in situations where the receptor apparatus 100 is coupled to a source apparatus. For example, in some embodiments, the receptor interface engine 103 may be configured to perform one or more of one or more second measurements of a voltage (VIV) at the first and second input signal terminals, one or more first measurements of a current (VIA) at one of the first and second terminals of the receptor apparatus, one or more second measurements of a current (VIAV) at one of the first and second terminals of the receptor apparatus, and one or more first measurements of a voltage (VIC) at the first and second input signal terminals.

The control engine 101 includes a processor, which may be any suitable microprocessor, microcontroller, Field Programmable Gate Arrays (FPGA), Application Specific Integrated Circuits (ASIC), Digital Signal Processing chip, and/or state machine, or a combination thereof. According to various embodiments, one or more of the computers can be configured as a multi-processor computer having multiple processors for providing parallel computing. The control engine 101 may also comprise, or may be in communication with, computer storage media, such as, without limitation, the memory 104, capable of storing computer program instructions or software code that, when executed by the processor, causes the processor to perform the elements described herein. In addition, the memory 104 may be any type of data storage computer storage medium, capable of storing a data structure representing a computer network to which the receptor apparatus 100 belongs, coupled to the control engine 101 and operable with the receptor interface engine 103 and the configuration engine 102 to facilitate management and processing of data stored in association therewith.

In embodiments of the present subject disclosure, the receptor apparatus 100 is configured for performing the methods described herein.

It will be appreciated that the receptor apparatus 100 shown and described with reference to Fig. 3 is provided by way of example only. Numerous other architectures, operating environments, and configurations are possible. Other embodiments of the receptor apparatus may include fewer or greater number of components, and may incorporate some or all of the functionality described with respect to the receptor apparatus components shown in Fig. 3. Accordingly, although the control engine 101, configuration engine 102, receptor interface engine 103, and memory 104 are illustrated as part of the receptor apparatus 100, no restrictions are placed on the location and control of components 102 - 104. In particular, in other embodiments, components 102 - 104 may be part of different entities or computing systems.

Depending on the embodiment, the apparatus 100, and one or more of the engines comprises therein, may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

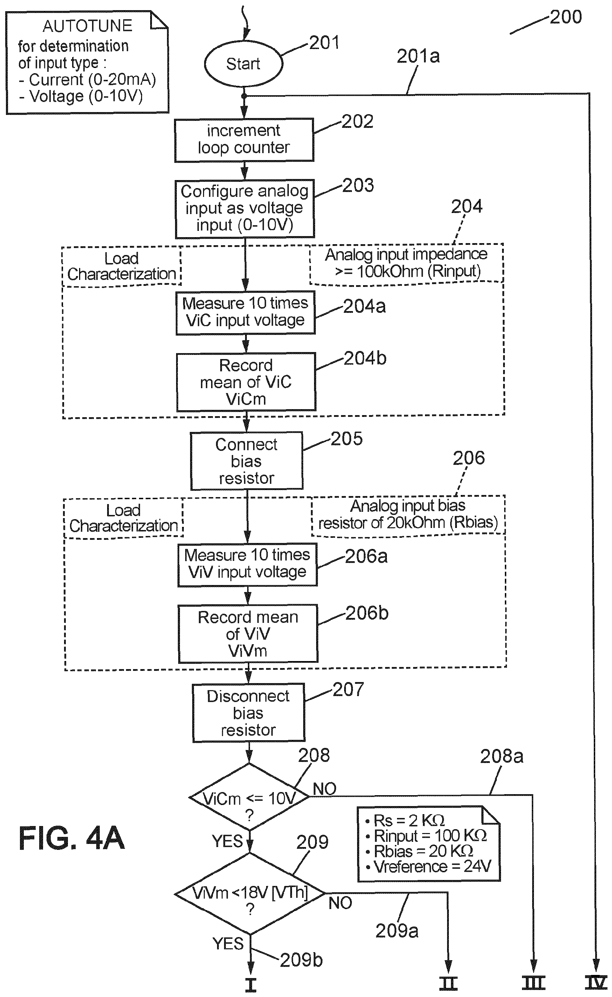

Fig. 4A shows a diagram illustrating a method for self-configuring a receptor apparatus according to one or more embodiments of the present subject disclosure.

The proposed method (200) illustrated on Fig. 4A corresponds to the exemplary context of a self-configuring of a receptor apparatus configured to use (comply with) some of the specifications of the standard specification IEC 61131-2. In particular, specific values used in the following description of Fig. 4A are exemplary numerical values that may in some embodiments be chosen for a receptor apparatus configured to use (comply with) some of the specifications of the standard specification IEC 61131-2.

For example, in one or more embodiments, specific numerical values used in the proposed "autotune" method for a receptor apparatus configured to use (comply with) some of the specifications of the standard specification IEC 61131-2 may correspond to an electrical input signal of the voltage input signal type having a voltage value between 0 V and 10 V, and to an electrical input signal of the current input signal type having a current value between 0 V and 20 mA.

The proposed scheme may start (201) with incrementing (202) a configuration loop counter, which will have been initialized to an initial value (e.g. 0) prior to starting a first iteration of the configuration loop.

Incrementing the configuration loop counter may be performed to start a new iteration of the configuration loop, which may be referred to as the "current iteration", which may comprise one or more of the operations shown on Fig. 4A and described in the following.

In one or more embodiments, the current iteration may start with configuring the input interface of the receptor apparatus as an analog voltage input. The configuring the input interface of the receptor apparatus as an analog voltage input may advantageously be performed in order to proceed with a determination as to whether the electrical input signal generated (supplied) by the source apparatus is or not a voltage input signal (is or not of the voltage input signal type) before performing a determination as to whether the electrical input signal generated (supplied) by the source apparatus is or not a current input signal (is or not of the current input signal type), as the determination as to whether the electrical input signal generated (supplied) by the source apparatus is or not a current input signal (is or not of the current input signal type) may involve injecting current to the source apparatus, which may damage the source apparatus in the cases where the electrical input signal generated (supplied) by the source apparatus is a current input signal.

In some embodiments, configuring the input interface of the receptor apparatus as an analog voltage input may comprise configuring the (analog) input impedance of the receptor apparatus as a high (resistive) impedance, e.g. through an input resistor having a resistive value higher than 100 kOhms.

In one or more embodiments, once the input interface of the receptor apparatus is configured as an analog voltage input, a first load characterization (204) may be performed, which may comprise measuring (204a) a first (input) voltage (ViC) at the input interface coupled to the source apparatus. In some embodiments, the measuring (204a) the voltage (ViC) at the input interface may be performed several times (e.g. 10 times), so that a plurality of first voltage measurements (ViC) may be obtained. In some embodiments, a first mean voltage value (ViCm) may be determined (204b) based on the plurality of first voltage measurements (ViC) and stored in memory (of the receptor apparatus). The first load characterization (204) may therefore result in some embodiments in a first mean voltage value (ViCm) corresponding to a mean of a plurality of first voltage measurements (ViC) of voltage at the input interface coupled to the source apparatus, the first voltage measurements (ViC) of voltage being performed once the input interface is configured with a high (resistive) input impedance.

In one or more embodiments, a second load characterization (206) may be performed once the (analog) input impedance of the receptor apparatus has been configured (205) with a bias (resistive) impedance. In some embodiments, the input interface of the receptor apparatus may be biased (205), e.g. through a bias resistor (for example having a resistive value in the order of 20 kOhm).

In one or more embodiments, once the input interface of the receptor apparatus is configured as a biased analog voltage input, a second load characterization (206) may be performed, which may comprise measuring (206a) a second (input) voltage (ViV) at the input interface coupled to the source apparatus. In some embodiments, the measuring (206a) the voltage (ViV) at the input interface may be performed several times (e.g. 10 times), so that a plurality of second voltage measurements (ViV) may be obtained. In some embodiments, a second mean voltage value (ViVm) may be determined (206b) based on the plurality of second voltage measurements (ViV), and stored in memory (of the receptor apparatus). The second load characterization (204) may therefore result in some embodiments in a second mean voltage value (ViVm) corresponding to a mean of a plurality of second voltage measurements (ViV) of voltage at the input interface coupled to the source apparatus, the first voltage measurements (ViC) of voltage being performed once the input interface is configured with a bias (in some embodiments in addition to being configured with a high (resistive) input impedance).

In one or more embodiments, once operations of the second load characterization (206) are completed, the bias (e.g. the bias resistor) of the input interface may be removed (207) therefrom.

In one or more embodiments, once the first load characterization (204) is complete, a first determination may be made (208) based on a comparison of one or more of the first voltage measurements (VIC) (in some embodiments of the first mean voltage measurement (VICm)) with a predefined first voltage threshold value. In some embodiments, the predefined first voltage threshold value may be chosen based on a maximum voltage value specified for an electrical input signal of the voltage input signal type by a suitable (standard) specification. For example, in embodiments in which the receptor apparatus is configured to follow (or comply with) specifications of the IEC 61131-2 standard specification, the predefined first voltage threshold value may be chosen to be equal to 10 V. This comparison may advantageously allow verifying that the electrical input signal, if determined to be of the voltage signal type, is within specifications of the standard specification used for (configuring) the source apparatus and the receptor apparatus.

In some embodiments, in cases where the one or more of the first voltage measurements (VIC) (in some embodiments the first mean voltage measurement (VICm)) are determined (208b) to be lower than the predefined first voltage threshold value, the proposed method may proceed with performing the second load characterization (206). In embodiments in which the second load characterization (206) has already been performed, a second determination may be made (209) based on a comparison of one or more of the second voltage measurements (VIV) (in some embodiments of the second mean voltage measurement (VIVm)) with a predefined second voltage threshold value (VTh). In some embodiments, the predefined second voltage threshold value may be chosen based on a maximum voltage value specified for an electrical input signal of the voltage input signal type by a suitable (standard) specification (and based on that second voltage measurements are performed with the input interface being biased). For example, in embodiments in which the receptor apparatus is configured to follow (or comply with) specifications of the IEC 61131-2 standard specification, the predefined second voltage threshold value may be chosen to be equal to 18 V.

In some embodiments, in cases where the one or more of the second voltage measurements (VIV) (in some embodiments the second mean voltage measurement (VIVm)) are determined (209b) to be (strictly) lower than the predefined second voltage threshold value (VTh), it may be determined that the electrical input signal received from the source apparatus is a voltage input signal, and the current iteration may end. Upon determining that the electrical input signal received from the source apparatus is a voltage input signal, the configuration loop may end and the proposed method may proceed with configuring (217a) the input interface as a voltage input. In embodiments in which the receptor apparatus is configured to follow (or comply with) specifications of the IEC 61131-2 standard specification, the input interface may be configured as a voltage input so as to receive an analog voltage input signal that complies with the IEC 61131-2 standard specification, that is, having a voltage value between 0V and 10V.

In one or more embodiments, in cases where the one or more of the first voltage measurements (VIC) (in some embodiments the first mean voltage measurement (VICm)) are determined (208a) to be not lower than the predefined first voltage threshold value, the current iteration may end and a test (216) may be performed to determine whether a predefined maximum number of iterations of the configuration loop has been reached.

In some embodiments, in cases where the predefined maximum number of iterations of the configuration loop has not been reached (216a), a new iteration of the configuration loop may be performed (201a) as described above.

In some embodiments, in cases where the predefined maximum number of iterations of the configuration loop has been reached (216b), the configuration loop may end and the proposed method may proceed with determining (217c) an error with respect to failure of the determination of the type of analog input signal generated (supplied) by the source apparatus. In some embodiments, this failure error may be signaled to a user of the receptor apparatus by any suitable means, for example through a user interface (e.g. through activating a light signal on the receptor apparatus that indicates to the user an error status).

In one or more embodiments, in cases where the one or more of the second voltage measurements (VIV) (in some embodiments the second mean voltage measurement (VIVm)) are determined (209a) to be not (strictly) lower than the predefined second voltage threshold value (VTh), the current iteration may proceed with further operations, in some embodiments with further operations performed once the electrical input signal has been determined not to be an voltage input signal.

In one or more embodiments, a proposed method may comprise one or more of the following operations, which in some embodiments may correspond to further operations performed upon determining that the electrical input signal is not a voltage input signal:
In one or more embodiments, operations performed during the current iteration may comprise performing a third determination (210) based on a comparison of one or more of the second voltage measurements (VIV) (in some embodiments of the second mean voltage measurement (VIVm)) with a predefined third voltage threshold value. In some embodiments, the predefined third voltage threshold value may be chosen based on a maximum voltage value specified for an electrical input signal of the voltage input signal type by a suitable (standard) specification. For example, in embodiments in which the receptor apparatus is configured to follow (or comply with) specifications of the IEC 61131-2 standard specification, the predefined third voltage threshold value may be chosen to be equal to 20 V.

In some embodiments, in cases where the one or more of the second voltage measurements (VIV) (in some embodiments the second mean voltage measurement (VIVm)) are determined (210b) to be greater than the predefined third voltage threshold value, a third load characterization (211) may be performed.

In some embodiments, in cases where the one or more of the second voltage measurements (VIV) (in some embodiments the second mean voltage measurement (VIVm)) are determined (210a) to be not greater than the predefined third voltage threshold value, the current iteration may end and the test (216) may be performed to determine whether a predefined maximum number of iterations of the configuration loop has been reached. In some embodiments, in cases where the predefined maximum number of iterations of the configuration loop has not been reached (216a), a new iteration of the configuration loop may be performed (201a) as described above. In some embodiments, in cases where the predefined maximum number of iterations of the configuration loop has been reached (216b), the configuration loop may end and the proposed method may proceed with determining (217c) an error with respect to failure of the determination of the type of analog input signal generated (supplied) by the source apparatus.

In one or more embodiments (in some embodiments in cases where the one or more of the second voltage measurements (VIV) (in some embodiments the second mean voltage measurement (VIVm)) are determined (210b) to be greater than the predefined third voltage threshold value), a third load characterization (211) may be performed. Operations of the third load characterization (211) may comprise configuring (211a) the input interface of the receptor apparatus as an analog current input.

In one or more embodiments, configuring the input interface of the receptor apparatus as an analog current input may advantageously be performed once it has been determined that the electrical input signal is not a voltage input signal, in order to avoid damaging the source apparatus during operations for determining whether the electrical input signal is a current input signal. In some embodiments, configuring the input interface of the receptor apparatus as an analog current input may comprise configuring the (analog) input impedance of the receptor apparatus as a low (resistive) impedance, e.g. through an input resistor corresponding to the normal operations of the receptor apparatus.

In one or more embodiments, operations of the third load characterization (211) may comprise measuring (211b) a first (input) current (ViA) at the input interface coupled to the source apparatus. In some embodiments, the measuring (211b) the current (ViA) at the input interface may be performed several times (e.g. 10 times), so that a plurality of first current measurements (ViA) may be obtained. In some embodiments, a first mean current value (ViAm) may be determined (211c) based on the plurality of first current measurements (ViA) and stored in memory (of the receptor apparatus). The third load characterization (211) may therefore result in some embodiments in a first mean current value (ViAm) corresponding to a mean of a plurality of first current measurements (ViA) of current at the input interface coupled to the source apparatus, the first current measurements (ViV) of current being performed once the input interface is configured with an input impedance corresponding to that configured for normal operations of the receptor apparatus.

In one or more embodiments, a fourth load characterization (213) may be performed once the (analog) input impedance of the receptor apparatus has been configured (212) with a bias (resistive) impedance. In some embodiments, the input interface of the receptor apparatus may be biased (212), e.g. through a bias resistor (for example having a resistive value in the order of 20 kOhm).

In one or more embodiments, once the input interface of the receptor apparatus is configured as a biased analog input, a fourth load characterization (213) may be performed, which may comprise second measuring (213a) a (input) current (ViAV) at the input interface coupled to the source apparatus. In some embodiments, the measuring (213a) the current (ViAV) at the input interface may be performed several times (e.g. 10 times), so that a plurality of second current measurements (ViAV) may be obtained. In some embodiments, a second mean current value (ViAVm) may be determined (213b) based on the plurality of second current measurements (ViAV), and stored in memory (of the receptor apparatus). The fourth load characterization (213) may therefore result in some embodiments in a second mean current value (ViAVm) corresponding to a mean of a plurality of second current measurements (ViAV) of current at the input interface coupled to the source apparatus, the second current measurements (ViAV) of current being performed once the input interface is configured with a bias.

In one or more embodiments, once operations of the fourth load characterization (212) are completed, the bias (e.g. the bias resistor) of the input interface may be removed (214) therefrom.

In one or more embodiments, once the third (211) and fourth (213) load characterizations are complete, a third determination may be made (215) based on one or more of the first current measurements (VIA) (in some embodiments of the first mean current measurement (VIAm)) and on one or more of the second current measurements (VIAV) (in some embodiments of the second mean current measurement (VIAVm)).

In one or more embodiments, the third determination (215) may comprise comparing one or more of the first current measurements (VIA) (in some embodiments of the first mean current measurement (VIAm)) with a predefined first current threshold value. In some embodiments, the predefined first current threshold value may be chosen based on a maximum current value specified for an electrical input signal of the current input signal type by a suitable (standard) specification. For example, in embodiments in which the receptor apparatus is configured to follow (or comply with) specifications of the IEC 61131-2 standard specification, the predefined first current threshold value may be chosen to be equal to 20 mA. This comparison may advantageously allow verifying that the electrical input signal, if determined to be of the current signal type, is within specifications of the standard specification used for (configuring) the source apparatus and the receptor apparatus.

In some embodiments, in cases where the one or more of the first current measurements (VIA) (in some embodiments of the first mean current measurement (VIAm)) are determined (215a) to be greater than the predefined first current threshold value, the current iteration may end and the test (216) may be performed to determine whether a predefined maximum number of iterations of the configuration loop has been reached. In some embodiments, in cases where the predefined maximum number of iterations of the configuration loop has not been reached (216a), a new iteration of the configuration loop may be performed (201a) as described above. In some embodiments, in cases where the predefined maximum number of iterations of the configuration loop has been reached (216b), the configuration loop may end and the proposed method may proceed with determining (217c) an error with respect to failure of the determination of the type of analog input signal generated (supplied) by the source apparatus.

In one or more embodiments, the third determination (215) may comprise comparing one or more of the second current measurements (VIAV) (in some embodiments of the second mean current measurement (VIAVm)) with a combination of one or more of the first current measurements (VIA) (in some embodiments of the first mean current measurement (VIAm)) and a predefined current value. In some embodiments, the comparison may use a predefined error margin.

In one or more embodiments, the third determination (215) may comprise determining whether the one or more of the second current measurements (VIAV) (in some embodiments of the second mean current measurement (VIAVm)) is substantially equal to a predefined combination (e.g. a sum) of one or more of the first current measurements (VIA) (in some embodiments of the first mean current measurement (VIAm)) and a predefined current value (e.g. a sum of the first mean current measurement (ViAm) and the predefined current value. In some embodiments, the determination may use a predefined error margin.

In some embodiments, one or more of the predefined current value and the predefined error margin may be chosen based on a maximum current value specified for an electrical input signal of the current input signal type by a suitable (standard) specification. For example, in embodiments in which the receptor apparatus is configured to follow (or comply with) specifications of the IEC 61131-2 standard specification, the predefined current value may be chosen to be equal to 0.95 mA. As another example in embodiments in which the receptor apparatus is configured to follow (or comply with) specifications of the IEC 61131-2 standard specification, the predefined error margin may be chosen to be equal to 0.25 mA.

For example, in embodiments in which the receptor apparatus is configured to follow (or comply with) specifications of the IEC 61131-2 standard specification, the third determination (215) may comprise the following test: $ViAVm \approx ViAm + \left(0.95mA\pm 0.25mA\right) ?$

In one or more embodiments, is cases where it is determined (215a) that the one or more of the second current measurements (VIAV) (in some embodiments of the second mean current measurement (VIAVm)) is not substantially equal to the predefined combination (e.g. the sum) of one or more of the first current measurements (VIA) (in some embodiments of the first mean current measurement (VIAm)) and the predefined current value (in some embodiments using a predefined error margin), the current iteration may end and the test (216) may be performed to determine whether a predefined maximum number of iterations of the configuration loop has been reached. In some embodiments, in cases where the predefined maximum number of iterations of the configuration loop has not been reached (216a), a new iteration of the configuration loop may be performed (201a) as described above. In some embodiments, in cases where the predefined maximum number of iterations of the configuration loop has been reached (216b), the configuration loop may end and the proposed method may proceed with determining (217c) an error with respect to failure of the determination of the type of analog input signal generated (supplied) by the source apparatus.

For example, in some embodiments in which the receptor apparatus is configured to follow (or comply with) specifications of the IEC 61131-2 standard specification, in cases where it is determined that the second mean current measurement (VIAVm) does not belong to the range [*ViAm +* 0.95mA - *0.25mA; ViAm +* 0.95mA *+ 0.25mA*]*,* the current iteration may end and the test (216) may be performed to determine whether a predefined maximum number of iterations of the configuration loop has been reached.

In one or more embodiments, in cases where the one or more of the first current measurements (VIA) (in some embodiments of the first mean current measurement (VIAm)) are determined to be not greater than the predefined first current threshold value, it may be determined that the electrical input signal received from the source apparatus is a current input signal, and the current iteration may end.

In one or more embodiments, in cases where the one or more of the second current measurements (VIAV) (in some embodiments of the second mean current measurement (VIAVm)) are determined to be substantially equal to the predefined combination (e.g. the sum) of one or more of the first current measurements (VIA) (in some embodiments of the first mean current measurement (VIAm)) and the predefined current value (in some embodiments using a predefined error margin), it may be determined that the electrical input signal received from the source apparatus is a current input signal, and the current iteration may end.

In one or more embodiments, in cases where the one or more of the first current measurements (VIA) (in some embodiments of the first mean current measurement (VIAm)) are determined (215b) to be not greater than the predefined first current threshold value and the one or more of the second current measurements (VIAV) (in some embodiments of the second mean current measurement (VIAVm)) are determined (215b) to be substantially equal to the predefined combination (e.g. the sum) of one or more of the first current measurements (VIA) (in some embodiments of the first mean current measurement (VIAm)) and the predefined current value (in some embodiments using a predefined error margin), it may be determined that the electrical input signal received from the source apparatus is a current input signal, and the current iteration may end.

Upon determining that the electrical input signal received from the source apparatus is a current input signal, the configuration loop may end and the proposed method may proceed with configuring (217b) the input interface as a current input. In embodiments in which the receptor apparatus is configured to follow (or comply with) specifications of the IEC 61131-2 standard specification, the input interface may be configured as a current input so as to receive an analog current input signal that complies with the IEC 61131-2 standard specification, that is, having a current value between 0mA and 20mA.

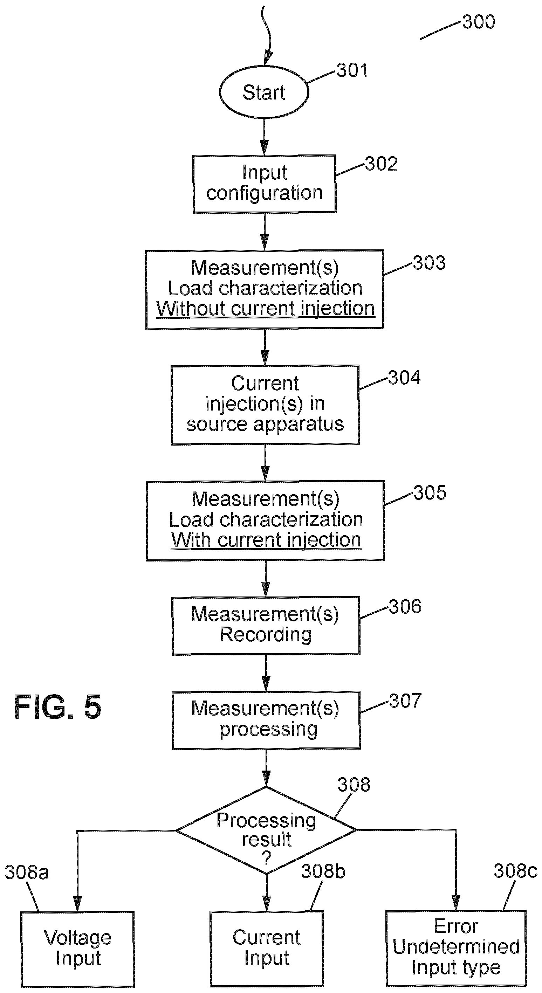

Fig. 5 shows a diagram illustrating a method (300) for self-configuring a receptor apparatus according to one or more embodiments of the present subject disclosure.

In one or more embodiments, the proposed scheme may start (301) with configuring (302) the input interface of the receptor apparatus as an analog voltage input or as an analog current input.

In some embodiments, the input interface of the receptor may be first configured as an analog voltage input. The configuring the input interface of the receptor apparatus as an analog voltage input may advantageously be performed first (instead of configuring the input interface as an analog current input) in order to proceed with a determination as to whether the electrical input signal generated (supplied) by the source apparatus is or not a voltage input signal (is or not of the voltage input signal type) before performing a determination as to whether the electrical input signal generated (supplied) by the source apparatus is or not a current input signal (is or not of the current input signal type), as the determination as to whether the electrical input signal generated (supplied) by the source apparatus is or not a current input signal (is or not of the current input signal type) may involve injecting current to the source apparatus, which may damage the source apparatus in the cases where the electrical input signal generated (supplied) by the source apparatus is a current input signal.

**In** one or more embodiments, once the input interface of the receptor apparatus is configured as an analog voltage input, a first load characterization (303) may be performed, which may comprise measuring one or more voltage values of voltage at the input interface coupled to the source apparatus. **In** some embodiments, the measuring the voltage at the input interface may be performed several times, so that a plurality of first voltage measurements may be obtained. **In** some embodiments, the first load characterization (303) may be performed for determining whether or not the input signal received from the source apparatus is a voltage signal (as opposed to a current signal), so that it may not use a current injection into the source apparatus.

**In** one or more embodiments, once the input interface of the receptor apparatus is configured as an analog current input, a second load characterization (305) may be performed, which may comprise measuring one or more current values of current at the input interface coupled to the source apparatus. **In** some embodiments, the second load characterization (305) may be performed for determining whether or not the input signal received from the source apparatus is a current signal (as opposed to a voltage signal), so that it may in some embodiments use one or more current injections (304) into the source apparatus.

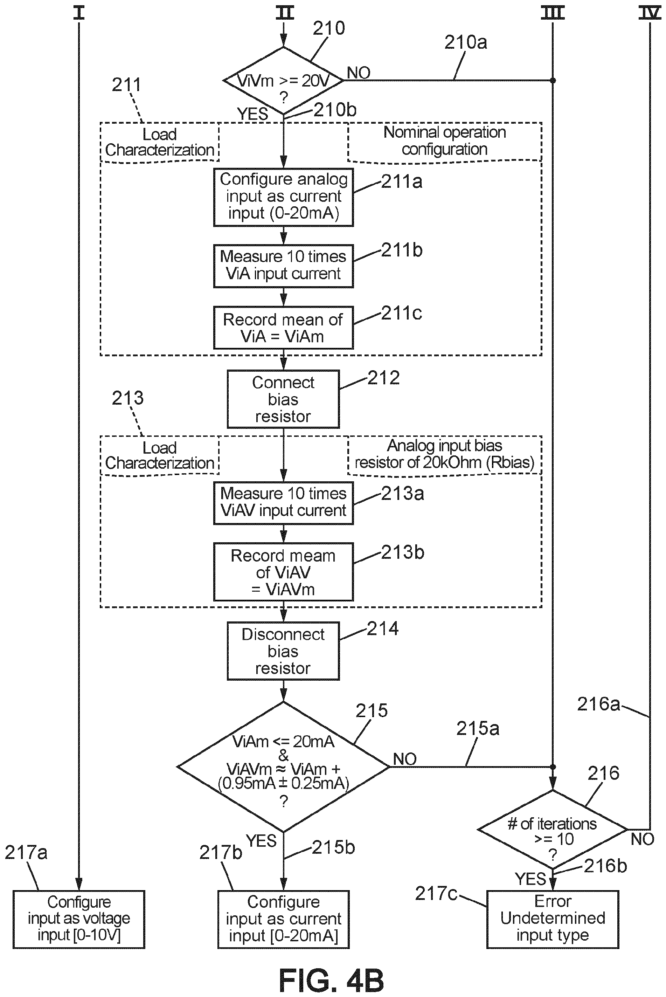

Once one or both of the first load characterization (303) and the second load characterization (305) are complete, results of the measurements performed for load characterization may be stored (306), and a test of the stored results may be performed (307) (for example as described in connection with Figs 4A and 4B) to determine (308) among one or more of the following load characterization results: the input signal received from the source apparatus is a voltage signal (308a), the input signal received from the source apparatus is a current signal (308b), and no determination can be made as to whether the input signal received from the source apparatus is a voltage signal or a current signal (308c).

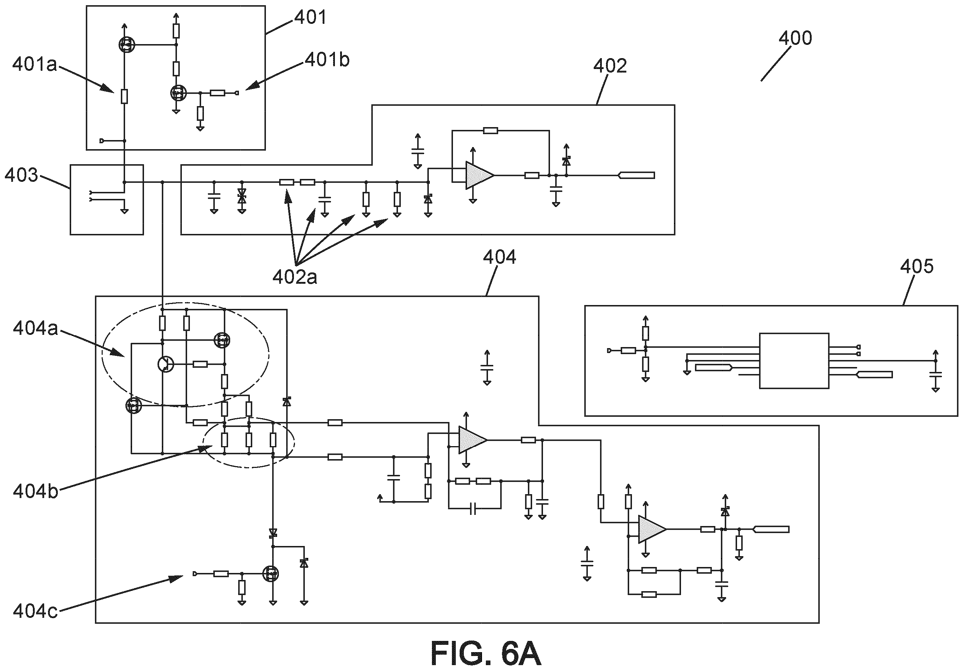

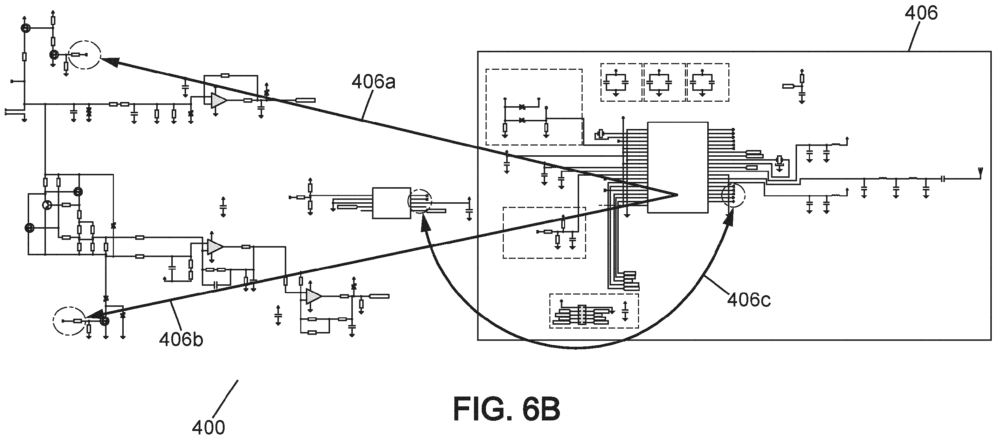

Figures 6a and 6b illustrate a receptor apparatus 400 configured to use features in accordance with embodiments of the present subject disclosure.

In one or more embodiments, the receptor apparatus 400 may include a bias system 401, an input adapter 402, one or more input connectors 403, and input adapter (for current input) 404, and Analog to Digital converter (ADC) 405, and a Microcontroller Unit (MCU) 406, a power supply (e.g., a battery, plug-in power supply, etc.) (not represented on the figure).

In the architecture illustrated on Figs. 6a and 6b, all of the bias system 401, input adapter (for voltage input) 402, one or more input connectors 403, input adapter (for current input) 404, and Analog to Digital converter (ADC) 405 are operatively coupled with one another through the Microcontroller Unit (MCU) 406.

In one or more embodiments, the bias system 401 is configured to perform various aspects of embodiments of the proposed methods for configuring a receptor apparatus as described herein, such as configuring a bias resistor in the input interface of the receptor apparatus. In some embodiments, the bias system 401 may comprise a bias resistor (401a) and a bias system driving gate 401b for configuring a bias resistor in the input interface of the receptor apparatus.

In one or more embodiments, the input adapter 402 is configured to perform various aspects of embodiments of the proposed methods for configuring a receptor apparatus as described herein, such as configuring the input interface of the receptor apparatus as a voltage input. In some embodiments, the input adapter 402 may comprise an input impedance system 402a for configuring the input interface of the receptor apparatus as a voltage input.

In one or more embodiments, the input adapter 404 is configured to perform various aspects of embodiments of the proposed methods for configuring a receptor apparatus as described herein, such as configuring the input interface of the receptor apparatus as a current input. In some embodiments, the input adapter 404 may comprise a shunt protection system 404a, one or more shunt resistors 404b, and a configuration input type driving gate (for voltage/current input) 404c, for configuring the input interface of the receptor apparatus as a current input.

As shown on Fig. 6b, the MUC 406 may in some embodiments be configured to drive (through one of its digital pin) 406a the bias system 401. In some embodiments, the MUC 406 may be configured to drive (through one of its digital pin) 406b one or more of the the input adapters 402 and 404, so that the MCU 406 may drive the analog input of the receptor apparatus 400 in voltage mode (analog voltage input) or in current mode (analog current input). In some embodiments, the MUC 406 may be coupled with the ADC 405 through a serial link (406c) in order to record analog input signals converted by the ADC 405.

In embodiments of the present subject disclosure, the receptor apparatus 400 is configured for performing the methods described herein.

It will be appreciated that the receptor apparatus 400 shown and described with reference to Figs. 6a and 6b is provided by way of example only. Numerous other architectures, operating environments, and configurations are possible. Other embodiments of the receptor apparatus may include fewer or greater number of components, and may incorporate some or all of the functionality described with respect to the receptor apparatus components shown in Figs. 6a and 6b. Accordingly, although the bias system 401, input adapter (for voltage input) 402, one or more input connectors 403, input adapter (for current input) 404, Analog to Digital converter (ADC) 405 and Microcontroller Unit (MCU) 406 are illustrated as part of the receptor apparatus 400, no restrictions are placed on the location and control of components 401 - 406. In particular, in other embodiments, components 401 - 405 may be part of different entities, electronic systems or computing systems.

Depending on the embodiment, the apparatus 400, and one or more of the engines comprises therein, may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

Advantages of the proposed schemes include in some embodiments that a high level of reliability can be achieved with a simple electronic design, using proven functional blocks, and a robust firmware, inspired by the coding rules of industrial systems: SIL4 .. SIL3 ... , or aeronautical systems: DAL A .. DAL B ... , or finally systems for medical use: Class 1 .. Class 2 .... These coding rules recommend, for example, a parsimonious use of loops, or a prohibition on the use of recursive functions.

In embodiments of the present subject disclosure, reliability may advantageously be reflected in the selection of the mode of operation, in voltage or current, according to criteria having a high certainty. In the case of multi-criteria choices, the margins of error will have minimal overlap.

While the invention has been described with respect to preferred embodiments, those skilled in the art will readily appreciate that various changes and/or modifications can be made to the invention without departing from the spirit or scope of the invention as defined by the appended claims.

Although this invention has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the invention. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

## Claims

1. A method for configuring a receptor apparatus adapted for processing an analog electrical input signal received from a source apparatus, the method comprising, the source apparatus being electrically coupled to the receptor apparatus through an input interface comprising a first and second input signal terminals of the receptor apparatus:
Performing one or more iterations of a configuration loop, an iteration of the configuration loop comprising:
• Performing, by the receptor apparatus, one or more second measurements of a voltage (VIV) at the first and second input signal terminals;
• Determining, by the receptor apparatus, based on the one or more second measurements of the voltage, whether the analog electrical input signal is a voltage input signal;
• Upon determining that the analog electrical input signal is a voltage input signal, configuring the input interface as a voltage input for processing the analog electrical input signal as a voltage input signal;
• Upon determining that the analog electrical input signal is not a voltage input signal, determining whether the analog electrical input signal is a current input signal;
• Upon determining that the analog electrical input signal is a current input signal, configuring the input interface as a current input for processing the analog electrical input signal as a current input signal.

2. A method according to claim 1, wherein the determining whether the analog electrical input signal is a current input signal comprises:
determining, based on the one or more second measurements of the voltage, whether or not an indetermination case is reached.

3. A method according to any of the preceding claims, further comprising: prior to performing the one or more second measurements of the voltage (VIV) at the first and second input signal terminals, connecting, by the receptor apparatus, a bias load to the first and second input signal terminals; and upon performing the one or more second measurements of the voltage (VIV) at the first and second input signal terminals, disconnecting, by the receptor apparatus, the bias load.

4. A method according to any of the preceding claims, wherein the determining whether the analog electrical input signal is a current input signal comprises:
Performing one or more first measurements of a current (VIA) at one of the first and second terminals of the receptor apparatus;
Performing shunt of the first and second terminals of the receptor apparatus by configuring a shunt resistor in parallel between the first and second terminals of the receptor apparatus;
Upon performing a current injection in the first terminal of the receptor apparatus, performing one or more second measurements of a current (VIAV) at one of the first and second terminals of the receptor apparatus;
Determining, based on comparing the one or more second measurements of a current (VIAV) with a combination of the one or more first measurements of a current (VIA) and the current injection, whether the analog electrical input signal is a current input signal.

5. A method according to claim 4, further comprising: performing a plurality of the second measurements of the current (VIAV), wherein the determining whether the analog electrical input signal is a current input signal is based on a mean of the plurality of the second measurements of the current (VIAV).

6. A method according to any of claims 4 and 5, further comprising: performing a plurality of the first measurements of the current (VIA), wherein the determining whether the analog electrical input signal is a current input signal is based on a mean of the plurality of the first measurements of the current (VIA).

7. A method according to any of claims 4 to 6, further comprising: Determining whether the one or more first measurements of a current (VIA) belong to a range of rated current values for the analog electrical input signal.

8. A method according to any of the preceding claims, wherein the determining, based on the one or more second measurements of the voltage, whether the analog electrical input signal is a voltage input signal comprises comparing the one or more second measurements of the voltage with a predefined voltage value.

9. A method according to any of the preceding claims, further comprising: prior to performing the one or more second measurements of the voltage (VIV) at the first and second input signal terminals, configuring an electrical analog input of the receptor as a voltage input.

10. A method according to any of the preceding claims, further comprising:
Performing one or more first measurements of a voltage (VIC) at the first and second input signal terminals;
Determining whether the one or more first measurements of the voltage belong to a range of rated voltage values for the analog electrical input signal.

11. A method according to any of the preceding claims, further comprising:
performing a plurality of the second measurements of the voltage (VIV), wherein the determining whether the analog electrical input signal is a voltage input signal is based on a mean of the plurality of the second measurements of the voltage.

12. A method according to any of the preceding claims, further comprising:
Performing a plurality of the first measurements of a voltage (VIC) at the first and second input signal terminals;
Determining a representative first voltage measurement value based on the plurality of first measurements of a voltage (VIC); and
Determining whether the representative first voltage measurement value belongs to a range of rated voltage values for the analog electrical input signal.

13. A method according to any of the preceding claims, further comprising, upon determining that the one or more first measurements of the voltage do not belong to the range of rated voltage values for the analog electrical input signal, determining a configuration error of the receptor apparatus.

14. An apparatus comprising a processor and a memory operatively coupled to the processor, wherein the apparatus is configured to perform a method according to any of claims 1 to 13.

15. A computer program product comprising computer program code tangibly embodied in a computer readable medium, said computer program code comprising instructions to, when provided to a computer system and executed, cause said computer to perform a method according to any of claims 1 to 13.
